# EUROPEAN PATENT APPLICATION

(11) **EP 4 145 537 A1**
(43) Date of publication of application: **08.03.2023**
(21) Application number: 20934036.3
(22) Date of filing: 05.06.2020
(51) Int. Cl.: H01L 31/0224

(54) **SHINGLE ASSEMBLY SCREEN STRUCTURE**

(30) Priority: 30.04.2020 CN 202010367506; 30.04.2020 CN 202020707632 U
(71) Applicant: ZHEJIANG JINKO SOLAR CO., LTD., Haining, Zhejiang 314416 (CN); JINKO SOLAR CO., LTD., ShangRao, Jiangxi 334100 (CN)
(72) Inventor: GUO, Zhiqiu, Yuan Hua Town Haining, Zhejiang 314416 (CN); WANG, Juan, Yuan Hua Town Haining, Zhejiang 314416 (CN); JIN, Yeyi, Yuan Hua Town Haining, Zhejiang 314416 (CN)
(74) Representative: DREISS Patentanwälte PartG mbB
(86) International application number: PCT/CN2020/094585
(87) International publication number: WO 2021/217786

(57) **Abstract**

A shingled module screen structure, comprising a solar cell body (10), and a plurality of front busbars that are arranged in parallel on the left side and the center part of the front surface of the solar cell body (10) and that are connected to the upper side and the lower side. The regions between adjacent front busbars are shingled solar cell units (11), the back surface of the shingled solar cell units (11) is provided with back busbars (20), and the front busbars and the back busbars (20) are perpendicular to the upper side of the solar cell body (10). The provision of front busbars and back busbars (20) makes the regions between adjacent front busbars into shingled solar cell units (11). The front busbars and the back busbars (20) of the shingled solar cell units (11) are parallel to the left side and the right side of the shingled solar cell units (11), so that during the shingling process of the shingled solar cell units (11) formed by cutting, solar cell cuts after breaking are directly shingled and connected, thus increasing production efficiency.

## Description

This application claims priority to Chinese Patent Application No. 202010367506.1, entitled "SHINGLE MODULE SCREEN STRUCTURE" and filed with the China Patent Office on April 30, 2020, and to Chinese Patent Application No. 202020707632.2, entitled "SHINGLE MODULE SCREEN STRUCTURE" and filed with the China Patent Office on April 30, 2020, the entire contents of which are incorporated herein by reference.

### TECHNICAL FIELD

The present disclosure relates to the technical field of photovoltaic module shingling, and in particular, to a shingled module screen structure.

### BACKGROUND

As the photovoltaic market has increasingly high requirements on high power, a shingled module is popular in the market for its high power and high conversion efficiency.

Solar cells of the shingled module are connected in the form of shingles with no spacing. More solar cells can be placed in the module of a same size, and surfaces of the solar cells are not shielded by solder cuts, which may have a larger area for power generation.

During the manufacturing of a shingled string (laser scribing - gluing - breaking - shingling), solar cell cuts after breaking may be rotated and then shingled. However, the rotation and the shingling of the solar cell cuts may lead to an increase in process steps as well as in process costs and process cycle, which increases manufacturing costs of the shingled module.

### SUMMARY

An objective of the present disclosure is to provide a shingled module screen structure to prevent rotation of solar cell cuts, which improves process efficiency and reduces process costs and module costs.

In order to solve the above technical problems, embodiments of the present disclosure provide a shingled module screen structure, including a solar cell body, and a plurality of front busbars that are arranged in parallel at a left side and a center part on a front surface of the solar cell body and connected to an upper side and a lower side of the solar cell body, shingled solar cell units are defined as regions between adjacent front busbars, back busbars are arranged on a back surface of the shingled solar cell units, and the front busbars and the back busbars are perpendicular to the upper side of the solar cell body.

In one or more embodiments, adjacent front busbars are spaced at an equal distance.

In one or more embodiments, in each of the shingled solar cell units, the back busbar is spaced from a right side of the shingled solar cell unit at an equal distance.

In one or more embodiments, the rightmost back busbar on the back surface of the solar cell body is located on the right edge of the solar cell body.

In one or more embodiments, the shingled module screen structure further includes back fingers arranged on the back surface of the solar cell body and perpendicular to the back busbars, and front fingers arranged on the front surface of the solar cell body and perpendicular to the front busbars.

In one or more embodiments, the shingled module screen structure further includes a cutting line provided on the front surface of the solar cell body, the cutting line is spaced from the nearest adjacent busbar in a range from 3 mm to 5 mm.

In one or more embodiments, the solar cell body is a single-sided solar cell body or a double-sided solar cell body.

In one or more embodiments, a thickness of the solar cell body ranges from 50 µm to 250 µm.

In addition, embodiments of the present disclosure further provide a shingled module screen structure, including a double-sided solar cell body, front busbars arranged on a front surface of the double-sided solar cell body and back busbars arranged on a back surface of the double-sided solar cell body, the front busbars are parallel to a left side on the front surface of the double-sided solar cell body and are spaced from each other at an unequal distance, the back busbars are arranged in parallel on the left side and a right side on the back surface of the double-sided solar cell body and between the left side and the right side, and a projection of at least one of the front busbars exists between projections of adjacent back busbars, or a projection of at least one of the back busbars exists between projections of adjacent front busbars.

In one or more embodiments, the shingled module screen structure further includes front fingers arranged on the front surface of the double-sided solar cell body and perpendicular to the front busbars, and back fingers arranged on the back surface of the double-sided solar cell body and perpendicular to the back busbars.

Compared with the related art, the shingled module screen structure according to the embodiments of the present disclosure has the following advantages.

In the shingled module screen structure according to the embodiments of the present disclosure, the configuration of the front busbars on the front surface and the back busbars on the back surface makes the regions between adjacent front busbars into shingled solar cell units. The front busbars and the back busbars of the shingled solar cell units are parallel to the left side and the right side of the shingled solar cell units, so that during the shingling process of the shingled solar cell units formed by cutting, solar cell cuts after breaking are directly shingled and connected without rotation, reducing complexity of the process, thus increasing production efficiency.

### BRIEF DESCRIPTION OF DRAWINGS

In order to better illustrate the technical solutions in the embodiments of the present disclosure or the related art, the accompanying drawings used in the description of the embodiments or the related art will be introduced below. It is apparent that, the accompanying drawings in the following description are only some embodiments of the present disclosure, and other drawings can be obtained by those of ordinary skill in the art from the provided drawings without creative efforts.
FIG. 1 is a schematic diagram of a backside structure in a shingled module screen structure according to some embodiments of the present disclosure;
FIG. 2 is a schematic diagram of another backside structure in a shingled module screen structure according to some embodiments of the present disclosure; and
FIG. 3 is a schematic diagram of still another backside structure in a shingled module screen structure according to some embodiments of the present disclosure.

### DESCRIPTION OF EMBODIMENTS

The technical solutions in the embodiments of the present disclosure will be described clearly and completely below with reference to the accompanying drawings in the embodiments of the present disclosure. It is appreciated that, the described embodiments are merely some of rather than all of the embodiments of the present disclosure. All other embodiments acquired by those skilled in the art without creative efforts based on the embodiments of the present disclosure shall fall within the protection scope of the present disclosure.

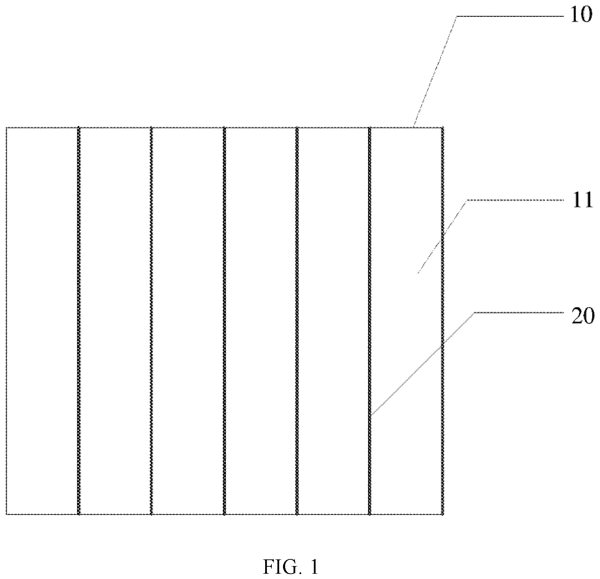

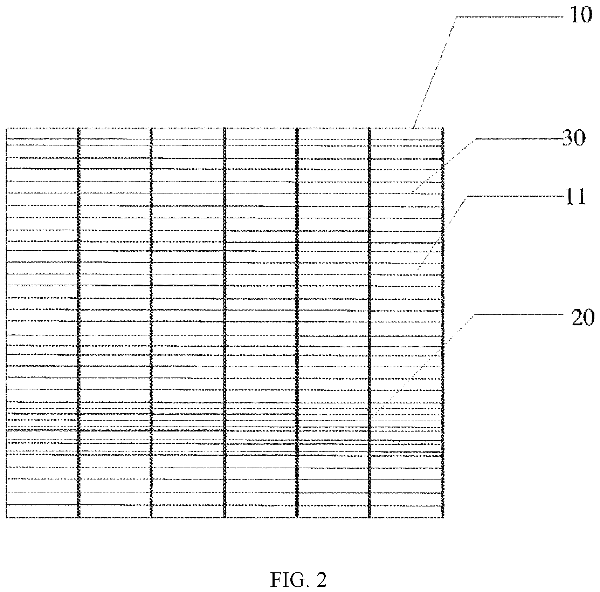

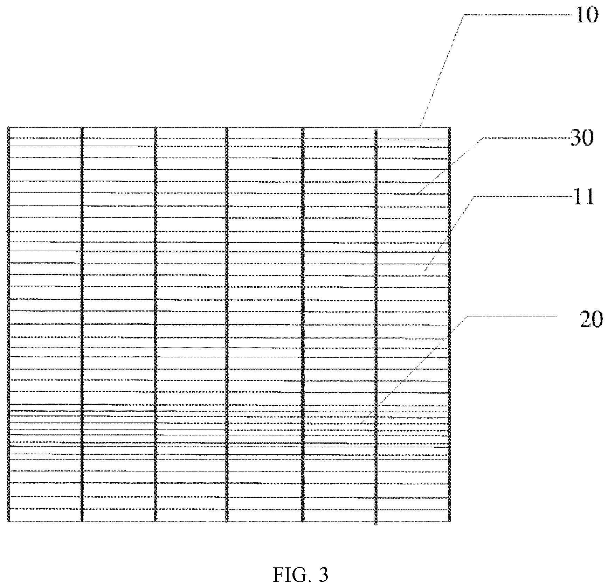

Referring to FIG. 1 to FIG. 3, FIG. 1 is a schematic diagram of a backside structure in a shingled module screen structure according to some embodiments of the present disclosure; FIG. 2 is a schematic diagram of another backside structure in a shingled module screen structure according to some embodiments of the present disclosure; and FIG. 3 is a schematic diagram of still another backside structure in a shingled module screen structure according to some embodiments of the present disclosure.

In some embodiments, the shingled module screen structure includes a solar cell body 10, and further includes a plurality of front busbars that are arranged in parallel on the left side and the center part of the front surface of the solar cell body 10 and that are connected to the upper side and the lower side. The regions between adjacent front busbars are shingled solar cell units 11, the back surface of the shingled solar cell units 11 is provided with back busbars 20, and the front busbars and the back busbars 20 are perpendicular to the upper side of the solar cell body 10.

The configuration of the front busbars on the front surface and the back busbars 20 on the back surface makes the regions between adjacent front busbars as shingled solar cell units 11. The front busbars and the back busbars 20 of the shingled solar cell units 11 are parallel to the left side and the right side of the shingled solar cell units 11, so that during the shingling process of the shingled solar cell units 11 formed by cutting, solar cell cuts after breaking are directly shingled and connected without rotation, reducing complexity of the process, thus increasing production efficiency.

In some embodiments, spacings between the adjacent front busbars are equal.

In the present disclosure, the size of the solar cell body 10 is not limited, and the spacings between adjacent front busbars are not limited. For example, the solar cell body 10 may be divided into 5, 6, or other numbers of shingled solar cell units 11 according to the busbars, and spacings between the front busbars are equal, so that the shingled solar cell units 11 of equal sizes can be easily obtained. In the present disclosure, the spacings between the busbars may be equal or unequal.

Since the solar cell body 10 in the present disclosure may finally be used to manufacture a shingled module, the back busbars 20 in the plurality of shingled solar cell units 11 are spaced from right sides of the shingled solar cell units 11 at a equal distance.

In order to improve utilization efficiency of the solar cells and reduce the shielding area during the shingling, in some embodiments of the present disclosure, the rightmost back busbar 20 on the back surface of the solar cell body 10 is located on the right edge on the back surface of the solar cell body 10.

During the shingling of the shingled module, the front busbars and the back busbars 20 are all located on sides of the shingled solar cell units 11. Direct overlapping in this way can minimize a covered area and thus increase a light receiving area of the solar cell body 10.

In the present disclosure, line widths of the front busbars and the back busbars 20 are not limited, and numbers thereof are not limited. The numbers thereof may be equal or unequal.

In order to further improve operation efficiency of the solar cells, in some embodiments of the present disclosure, the shingled module screen structure further includes back fingers 30 arranged on the back surface of the solar cell body 10 and perpendicular to the back busbars 20 and front fingers arranged on the front surface of the solar cell body 10 and perpendicular to the front busbars.

In the present disclosure, line widths and spacings of the front fingers and the back fingers 30 are not limited. In this way, current collecting capability can be improved, and efficiency of the solar cells can be improved.

In the present disclosure, to manufacture the shingled module screen structure, there is a need to cut the solar cell body 10, which may be cut by laser or in other manners. The cutting manner is not limited in the present disclosure. However, during the cutting, a slight disturbance may cause an actual cutting direction to be deflected, which may not be perpendicular to or even intersect with the busbars. In this way, deflection is required to be identified in the later shingling process. In order to facilitate an operator to monitor a cutting process and improve cutting efficiency, in some embodiments of the present disclosure, the shingled module screen structure further includes a cutting line provided on the front surface of the solar cell body 10, and a spacing between the cutting line and the nearest adjacent busbar ranges from 3 mm to 5 mm.

The configuration of the cutting line on the front surface of the solar cell body 10 (the cutting line may also be arranged on the back surface) enables the operator to judge, during the cutting, the cutting effect by judging a position difference between an actual cutting line and a preset cutting line of laser cutting or mechanical cutting, which can be immediately detected once deflection occurs, thereby improving the quality of the cutting process and reducing or preventing cutting error.

The cutting line in the present disclosure may be arranged in a manner similar to the busbars, which is designed in different colors, and a width thereof may be determined according to an actual cutting line width, which is not limited in the present disclosure.

The type of the solar cell body 10 in the present disclosure is not limited, which may be a monocrystalline silicon wafer or a polycrystalline silicon wafer, or a solar cell made of other materials. Moreover, the solar cell body 10 may be a single-sided solar cell body 10 or a double-sided solar cell body 10.

A thickness of the solar cell is not limited in the present disclosure. A thickness of the solar cell body 10 ranges from 50 µm to 250 µm.

In some embodiments, the solar cell body 10 is a single-sided solar cell body 10 and has a thickness of 150 µm, having a first surface which is the front surface and printed with a metal pattern and includes front busbars and front fingers, and a second surface which is the back surface and printed with a metal pattern and includes back busbars 20. The first surface is the front surface, one front busbar is located on a left edge of the solar cell body 10, and the remaining front busbars are evenly spaced on the front surface. Only one back busbar 20 is located on an edge of the back surface of the solar cell body 10, and the remaining busbars are evenly spaced on the back surface. The rightmost back busbar 20 on the back surface is arranged on a right edge of the solar cell body 10. The left edge is parallel to the right edge.

The solar cell body 10 includes 5 or 6 discontinuous regions. Such regions are shingled solar cell units 11. Each region is provided with a front busbar and a back busbar. The solar cell may be divided into a plurality of solar cell cuts. Each solar cell cut is a shingled solar cell unit 11. The solar cell cuts have equal widths. Each solar cell cut is provided with a front edge busbar and a back edge busbar respectively located on two edges of the solar cell cut.

A chamfer may be generally provided on the left edge or the right edge, resulting in a smaller actual area or light receiving area of the corresponding shingled solar cell unit 11. The operator may appropriately design the width of the shingled solar cell unit 11 with the two edges to be wider.

In some embodiments, the solar cell is a double-sided solar cell having first and second surfaces and has a thickness of 150 µm. Efficiency of the first surface is greater than or equal to that of the second surface. The first surface is printed with a metal pattern and includes busbars and fingers. The second surface is printed with a metal pattern and includes busbars and fingers. The first surface is the front surface, one front busbar is located on a left edge of the solar cell, and the remaining front busbars are evenly spaced on the solar cell body 10. The second surface is the back surface, only one back busbar 20 is located on a right edge of the solar cell, and the remaining back busbars 20 are evenly spaced on the solar cell body 10. When the remaining busbars on the first surface are unequally spaced, two or more of the busbars on the first surface are adjacent. The solar cell includes 5 or 6 discontinuous regions, each region is provided with a front busbar and a back busbar. The solar cell body 10 may be divided into a plurality of solar cell cuts. The solar cell cuts have basically equal widths. Each solar cell cut is provided with a front edge busbar and a back edge busbar respectively located on two edges (a left edge and a right edge) of the solar cell cut.

In addition, some embodiments of the present disclosure further provide a shingled module screen structure, including a double-sided solar cell body 10, and further including a front busbar arranged on the front surface of the double-sided solar cell body 10 and a back busbar 20 arranged on the back surface of the double-sided solar cell body 10. A plurality of front busbars are parallel to the left side on the front surface of the double-sided solar cell body 10 and are not equal, a plurality of back busbars 20 are arranged in parallel on the left side and the right side of the back surface of the double-sided solar cell body 10 and between the left side and the right side of the back surface of the double-sided solar cell body 10. The back busbar 20 and the front busbar reside in the double-sided solar cell body 10. A projection of at least one of the front busbars exists between projections of adjacent back busbars 20, or a projection of at least one of the back busbars 20 exists between projections of adjacent front busbars.

Compared with the above shingled module screen structure, the current shingled module screen structure is basically the same except that the busbars have not to be evenly spaced, and thus also brings the same beneficial effect. Details are not described herein in the present disclosure.

In order to further improve operation efficiency of the solar cells, in some embodiments of the present disclosure, the shingled module screen structure further includes front fingers arranged on the front surface of the double-sided solar cell body 10 and perpendicular to the front busbars and back fingers 30 arranged on the back surface of the double-sided solar cell body 10 and perpendicular to the back busbars 20.

By increasing the front fingers and the back fingers 30, current collecting capability of the solar cell body 10 is improved, operation efficiency of the solar cell is improved, current collecting capability of the module after the formation of the shingled module is also improved, and thus operation efficiency of the shingled module is improved.

In some embodiments, the solar cell body 10 is a double-sided solar cell body having a first surface and a second surface and has a thickness of 150 µm. Efficiency of the first surface is greater than or equal to that of the second surface. The first surface is printed with a metal pattern and includes busbars and fingers. The second surface is printed with a metal pattern and includes busbars and fingers. The first surface is the front surface, no front busbar is located on edges on the front surface of the solar cell, and a plurality of front busbars are not evenly spaced on the front surface of the solar cell. The second surface is the back surface, two back busbars 20 are located on edges (a left edge and a right edge) on the back surface of the solar cell, and the remaining busbars are not evenly spaced on the back surface of the solar cell. The solar cell body 10 includes 5 or 6 discontinuous regions (shingled solar cell units 11). Each region is provided with a front busbar and a back busbar. The solar cell body may be divided into a plurality of solar cell cuts. The solar cell cuts have equal widths. Each solar cell cut is provided with a front edge busbar and a back edge busbar respectively located on two edges of the solar cell cut.

Based on the above, in the shingled module screen structure according to the embodiments of the present disclosure, the configuration of the front busbars on the front surface and the back busbars on the back surface makes the regions between adjacent front busbars into shingled solar cell units. The front busbars and the back busbars of the shingled solar cell units are parallel to the left side and the right side of the shingled solar cell units, so that during the shingling process of the shingled solar cell units formed by cutting, solar cell cuts after breaking are directly shingled and connected without rotation, reducing complexity of the process, thus increasing production efficiency.

The shingled module screen structure according to the present disclosure has been introduced in detail above. Specific examples are used herein to elaborate principles and embodiments of the present disclosure, and descriptions of the above embodiments are used merely for helping understand the method of the present disclosure and the core idea thereof. It should be noted that those of ordinary skill in the art can also make several improvements and modifications to the present disclosure without departing from the principles of the present disclosure. Such improvements and modifications also fall within the protection scope of the claims of the present disclosure.

## Claims

1. A shingled module screen structure, comprising a solar cell body, and a plurality of front busbars that are arranged in parallel at a left side and a center part on a front surface of the solar cell body and connected to an upper side and a lower side of the solar cell body, wherein shingled solar cell units are defined as regions between adjacent front busbars, back busbars are arranged on a back surface of the shingled solar cell units, and the front busbars and the back busbars are perpendicular to the upper side of the solar cell body.

2. The shingled module screen structure according to claim 1, wherein adjacent front busbars are spaced at an equal distance.

3. The shingled module screen structure according to claim 2, wherein in each of the shingled solar cell units, the back busbar is spaced from a right side of the shingled solar cell unit at an equal distance.

4. The shingled module screen structure according to claim 3, wherein the rightmost back busbar on the back surface of the solar cell body is located on the right edge of the solar cell body.

5. The shingled module screen structure according to claim 4, further comprising back fingers arranged on the back surface of the solar cell body and perpendicular to the back busbars, and front fingers arranged on the front surface of the solar cell body and perpendicular to the front busbars.

6. The shingled module screen structure according to claim 5, further comprising a cutting line provided on the front surface of the solar cell body, wherein the cutting line is spaced from the nearest adjacent busbar in a range from 3 mm to 5 mm.

7. The shingled module screen structure according to claim 6, wherein the solar cell body is a single-sided solar cell body or a double-sided solar cell body.

8. The shingled module screen structure according to claim 7, wherein a thickness of the solar cell body ranges from 50 µm to 250 µm.

9. A shingled module screen structure, comprising a double-sided solar cell body, front busbars arranged on a front surface of the double-sided solar cell body and back busbars arranged on a back surface of the double-sided solar cell body, wherein the front busbars are parallel to a left side on the front surface of the double-sided solar cell body and are spaced from each other at an unequal distance, the back busbars are arranged in parallel on the left side and a right side on the back surface of the double-sided solar cell body and between the left side and the right side, and a projection of at least one of the front busbars exists between projections of adjacent back busbars, or a projection of at least one of the back busbars exists between projections of adjacent front busbars.

10. The shingled module screen structure according to claim 9, further comprising front fingers arranged on the front surface of the double-sided solar cell body and perpendicular to the front busbars, and back fingers arranged on the back surface of the double-sided solar cell body and perpendicular to the back busbars.
